# EUROPEAN PATENT APPLICATION

(11) **EP 1 521 369 A1**
(43) Date of publication of application: **06.04.2005**
(21) Application number: 04022162.4
(22) Date of filing: 17.09.2004
(51) Int. Cl.: H03L 7/00, H04B 1/16, H04B 1/04, H04B 1/40

(54) **Clock signal correcting circuit and communicating apparatus**

(30) Priority: 30.09.2003 JP 2003341614; 30.09.2003 JP 2003341615
(71) Applicant: Seiko Epson Corporation, Shinjuku-ku, Tokyo 163-0811 (JP)
(72) Inventor: Karaki, Isuke Seiko Epson Corporation, Suwa-shi Nagano-ken 392-8502 (JP)
(74) Representative: Hoffmann, Eckart, Dipl.-Ing.

(57) **Abstract**

The phase of a clock signal output from an SAW oscillator (3) is corrected by a phase control section (8) so that a signal synchronizing with the carrier wave of a standard time and frequency signal, that is, a carrier wave signal phase-synchronizes with the phase-corrected clock signal. Therefore, when a standard time and frequency signal can be received, it is possible to correct a clock signal in accordance with a carrier wave signal which can be generated from the standard time and frequency signal anytime. Therefore, even if the operational environment (for example, temperatures) of the SAW oscillator (3) is changed and the phase of a clock signal output from the SAW oscillator (3) is fluctuated due to the change, it is possible to synchronize the fluctuated clock signal with a standard time and frequency signal, that is, the carrier wave of a radio wave for providing a very accurate frequency standard and time service signal and, as a result, it is possible to improve the accuracy of the clock signal in accordance with the correction.

## Description

### BACKGROUND OF THE INVENTION

### Field of the Invention

The present invention relates to a clock signal correcting circuit for correcting a clock signal output from a predetermined oscillator and a communicating apparatus using the clock signal correcting circuit.

### Description of the Related Art

As this type of the technique, there is a technique for receiving a standard time and frequency signal which is a radio wave for providing a very accurate frequency standard and a time service signal, correcting the time of a built-in clock in accordance with the time service signal included in the received standard time and frequency signal, correcting a clock signal output from a highly-stable voltage control quartz oscillator by the corrected built-in clock, and thereby improving the accuracy of the clock signal output from the voltage control quartz oscillator (for example, refer to Japanese Patent Laid-Open No. 12-206276 (JP12-206276A)).

Moreover, in the case of JP12-206276A, by using a clock signal corrected by the method, a clock signal of a communication counterpart is made to accurately synchronize with a clock signal of its own. In this case, a time service signal is normally provided every minute by a standard time and frequency signal.

However, in the case of the former of the above prior arts, the time of a built-in clock is corrected in accordance with a time service signal provided every minute. Therefore, when the time of the built-in clock fluctuates immediately after receiving the time service signal (immediately after correcting the built-in clock), a clock signal is corrected (changed for the worse) by the built-in clock whose time fluctuates until a new time service signal is provided (for one minute until the time of the built-in clock is corrected). As a result, the accuracy of the clock signal maybe deteriorated due to the correction (change for the worse).

Moreover, in the case of the latter of the prior arts, when the time of a built-in clock fluctuates immediately after receiving a time service signal (immediately after correcting the built-in clock), a clock signal is corrected (changed for the worse) by the built-in clock whose time fluctuates until a new time service signal is provided (for one minute until the time of the built-in clock is corrected). As a result, the sync accuracy between a clock signal of a communication counterpart and a clock signal of its own may be deteriorated.

### SUMMARY OF THE INVENTION

The present invention is made to solve the above conventional problems and it is the first obj ect of the present invention to provide a clock signal correcting circuit capable of improving the accuracy of a clock signal.

Moreover, it is the second obj ect of the present invention to provide a communicating apparatus capable of accurately synchronizing a clock signal by using the clock signal correcting circuit for the communicating apparatus.

To solve the above problems, the clock signal correcting circuit which is the first invention is a clock signal correcting circuit for correcting a clock signal output from a predetermined oscillator, which comprises a standard time and frequency signal receiving section for receiving a standard time and frequency signal, a carrier wave signal generating section for generating a carrier wave signal synchronizing with the carrier wave of the received standard time and frequency signal, and a phase correcting section for correcting the phase of the clock signal so that the generated carrier wave signal phase-synchronizes with the clock signal.

Moreover, in the case of the clock signal correcting circuit which is the second invention, the predetermined oscillator is an SAW oscillator.

Furthermore, in the case of the clock signal correcting circuit which is the third invention, the phase correcting section corrects the phase of the clock signal so that the carrier wave signal generated by the carrier wave signal generating section phase-synchronizes with the clock signal when the standard time and frequency signal receiving section receives a standard time and frequency signal and stops the correction of the phase when the standard time and frequency signal receiving section does not receive a standard time and frequency signal.

According to these first to third inventions, it is possible to correct a clock signal in accordance with a carrier wave signal which can be generated from a standard time and frequency signal anytime when the standard time and frequency signal is received. Therefore, for example, even if operational environments (such as temperatures) of an oscillator are changed and the phase of a clock signal output from the oscillator is fluctuated due to the change, it is possible to phase-synchronize the fluctuated clock signal with the carrier wave of a standard time and frequency signal (radio wave for providing a very accurate frequency standard and a time service signal). As a result, it is possible to improve the accuracy of the clock signal according to the correction.

A communicating apparatus which is the fourth invention is a communicating apparatus capable of performing at least either of transmission and reception of predetermined data, which comprises a standard time and frequency signal receiving section for receiving a standard time and frequency signal, a carrier wave signal generating section for generating a carrier wave signal synchronizing with the carrier wave of the received standard time and frequency signal, a phase correcting section for correcting the phase of a clock signal output from a predetermined oscillator so that the generated carrier wave signal phase-synchronizes with the clock signal, and a communicating section capable of performing at least either of transmission and reception of the predetermined data in accordance with the corrected clock signal.

Moreover, in the case of the communicating apparatus which is the fifth invention, the predetermined oscillator is an SAW oscillator.

Furthermore, in the case of the communicating apparatus which is the sixth invention, the communicating section is able to perform at least either of transmission and reception of the predetermined data in accordance with the clock signal whose phase is corrected by the phase correcting section when the standard time and frequency signal receiving section receives a standard time and frequency signal and able to perform at least either of transmission and reception of the predetermined data in accordance with a clock signal output from the predetermined oscillator when the standard time and frequency signal receiving section does not receive a standard time and frequency signal.

According to these fourth to sixth inventions, it is possible to correct a clock signal in accordance with a carrier wave signal which can be generated from the standard time and frequency signal anytime when the standard time and frequency signal is received. Therefore, even if operational environments (such as temperatures) of a communicating apparatus are changed and the phase of a clock signal output from an oscillator is fluctuated due to the change, it is possible to phase-synchronize the fluctuated clock signal with the carrier wave of a standard time and frequency signal (radio wave for providing a very accurate frequency standard) and as a result, it is possible to accurately synchronize a clock signal of a communication counterpart with a clock signal of its own.

### BRIEF DESCRIPTION OF THE DRAWINGS

FIG. 1 is a block diagram showing an embodiment of the present invention; and
FIG. 2 is a block diagram showing a schematic configuration of the radio communicating apparatus in FIG. 1.

### DETAILED DESCRIPTION OF THE PREFERRED EMBODIMENTS

An example of constituting a radio communicating system capable of mutually transmitting and receiving predetermined data in accordance with radio by a plurality of communicating apparatuses respectively using a clock signal correcting circuit of the present invention will be described below by referring to the accompanying drawings.

### <Configuration of radio communicating system>

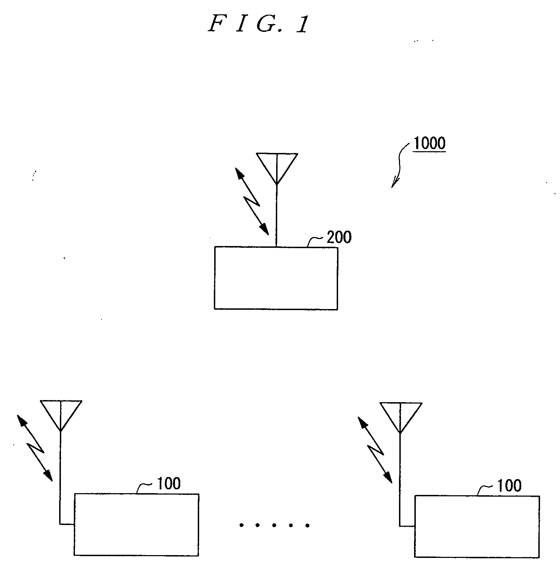

FIG. 1 is a schematic block diagram of the radio communicating system of this embodiment. As shown in FIG. 1, the radio communicating system 1000 is constituted by including a plurality of radio communicating apparatuses 100 and one apparatus (hereafter also referred to as "standard time and frequency signal transmitter") 200 for transmitting a standard time and frequency signal which is a radio wave for providing a very accurate frequency standard (e.g. 40 kHz) and a time service signal.

### <Configuration of radio communicating apparatus>

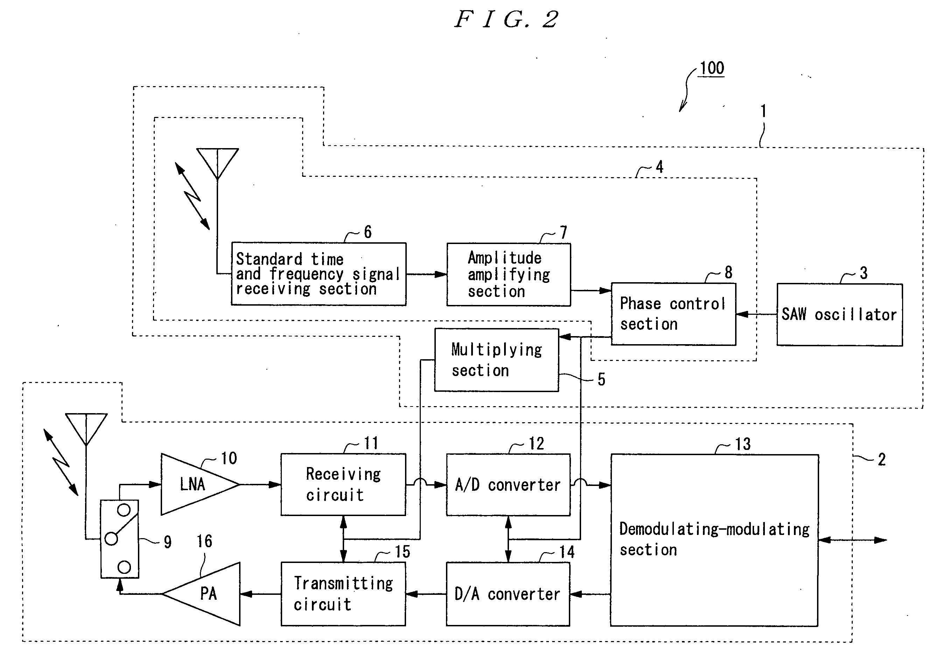

Moreover, as shown in FIG. 2, the radio communicating apparatus 100 is constituted by including a clock signal generating unit 1 and a radio communicating unit 2. The clock signal generating unit 1 is a unit for generating an accurate clock signal and outputting the clock signal to the radio communicating unit 2, which is constituted by including an SAW (surface acoustic wave) oscillator 3, a clock signal correcting circuit 4, and a multiplying section 5.

Among these components, the SAW oscillator 3 generates a clock signal at a predetermined cycle (for example, several hundreds MHz) and outputs the generated clock signal to the clock signal correcting circuit 4.

Moreover, the clock signal correcting circuit 4 is a circuit for correcting the phase of a clock signal output from the SAW oscillator 3 and outputting the clock signal to the radio communicating unit 2 and a multiplying section 5 (to be described later), which is constituted by including a standard time and frequency signal receiving section 6, amplitude amplifying section 7, and phase control section 8.

The standard time and frequency signal receiving section 6 has an antenna capable of receiving a standard time and frequency signal of 40 kHz transmitted from the standard time and frequency signal transmitter 200. Moreover, when the antenna receives the standard time and frequency signal, the standard time and frequency signal receiving section 6 generates a signal of 40 kHz (hereafter also referred to as "carrier wave signal") synchronizing with the carrier wave of the standard time and frequency signal and outputs the generated carrier wave signal to the amplitude amplifying section 7.

Moreover, when a carrier wave signal is output from the standard time and frequency signal receiving section 6, the amplitude amplifying section 7 amplifies the output carrier wave signal and outputs the amplified carrier wave signal to the phase control section 8.

Furthermore, when a carrier wave signal is output from the amplitude amplifying section 7, the phase control section 8 corrects the phase of a clock signal output from the SAW oscillator 3 in accordance with the carrier wave signal to phase-synchronize the corrected clock signal with a carrier wave signal (signal of 40 kHz) output from the amplitude amplifying section 7. Furthermore, the phase control section 8 outputs the phase-synchronized clock signal to the multiplying section 5, an A/D converter 12 (to be described later) of the radio communicating unit 2, and a D/A converter 14 (to be described later) of the radio communicating unit 2.

Furthermore, when a carrier wave signal is not output from the standard time and frequency signal receiving section 6 (when a no-signal state is set), the phase control section 8 divides a clock signal output from the SAW oscillator 3 and outputs it to the multiplying section 5, an A/D converter 12 (to be described later) of the radio communicating unit 2 and a D/A converter 14 (to be described later) of the radio communicating unit 2. A clock signal output from the phase control section 8 is hereafter referred to as "first clock signal".

Furthermore, the multiplying section 5 multiplies the frequency of a second clock signal output from the clock signal correcting circuit 4 (phase control section 8) by a predetermined value (for example, 1,000) and outputs the first clock signal multiplied by the predetermined value to a receiving circuit 11 (to be described later) and a transmitting circuit 15 (to be described later) of the radio communicating unit 2. A clock signal output from the phase control section 8 is hereafter referred to as "second clock signal".

The radio communicating unit 2 is a unit for transmitting and receiving various predetermined data values such as music data, image data, and document data in accordance with radio, which is constituted by including an antenna switching device 9, LNA (Low Noise Amplifier) 10, receiving circuit 11, A/D converter 12, demodulating-modulating section 13, D/A converter 14, transmitting circuit 15, andPA (PowerAmplifier) 16.

Moreover, the antenna switching device 9 has an antenna capable of receiving a transmission radio wave transmitted from another radio communicating apparatus 100 and transmitting a transmission radio wave having an intensity corresponding to the intensity of a signal output from the PA 16 of its own. Furthermore, when the antenna of the antenna switching device 9 receives a transmission radio wave from another radio communicating apparatus 100 serving as a communication counterpart, the antenna switching device 9 outputs a signal having an intensity corresponding to the intensity of the received transmission radio wave to the LNA 10. Furthermore, when a signal is output from the PA 16, the antenna switching device 9 outputs a transmission radio wave having an intensity corresponding to the intensity of the output signal to another radio communicating apparatus 100 serving as a communication counterpart from the antenna.

Furthermore, the LNA 10 amplifies a signal output from the antenna switching device 9 to predetermined times (e.g. 100 times) and outputs the signal amplified to predetermined times to the receiving circuit 11.

Furthermore, the receiving circuit 11 operates at the timing decided by the second clock signal generated by the clock signal generating unit 1 (multiplying section 5) to output a signal (hereafter also referred to as "data signal") having an intensity corresponding to the intensity of a signal output from the LNA 10 to the A/D converter 12.

Furthermore, the A/D converter 12 operates at the timing decided by the first clock signal output from the clock signal generating unit 1 (phase control section 8) to convert a data signal output from the receiving circuit 11 into a digital signal. Then, the A/D converter 12 outputs the data signal converted into the digital signal to a demodulating-modulating section 13.

Furthermore, when a data signal is output from the A/D converter 12, the demodulating-modulating section 13 demodulates the output data signal and outputs the demodulated data signal to another circuit (not illustrated). Furthermore, when a data signal is output from another circuit (not illustrated), the demodulating-modulating section 13 modulates the output data signal and outputs the modulated data signal to the D/A converter 14.

Furthermore, the D/A converter 14 operates at the timing decided by the first clock signal output from the clock signal generating unit 1 (phase control section 8) to convert a data signal output from the demodulating-modulating section 13 into an analog signal. Then, the D/A converter 14 outputs the data signal converted into the analog signal to the transmitting circuit 15.

Furthermore, the transmitting circuit 15 operates at the timing decided by the second clock signal generated by the clock signal generating unit 1 (multiplying section 5) and outputs a signal having an intensity corresponding to the intensity of a data signal output from the D/A converter 14 to the PA 16.

Furthermore, the PA 16 amplifies a signal output from the transmitting circuit 15 to predetermined times (e.g. 100 times) and outputs the signal amplified to the predetermined times to the antenna switching device 9.

### <Operations of radio communicating apparatus>

Then, operations of the radio communicating apparatus 100 of this embodiment will be specifically described below.

First, it is assumed that the standard time and frequency signal receiving section 6 receives a standard time and frequency signal. Then, a signal of 40 kHz (carrier wave signal) synchronizing with the carrier wave of the received standard time and frequency signal is generated by the standard time and frequency signal receiving section 6 and the carrier wave signal of the signal is output to the amplitude amplifying section 7. Moreover, the output carrier wave signal is amplified by the amplitude amplifying section 7 and the amplified carrier wave signal is output to the phase control section 8. Furthermore, the phase of a clock signal output from the SAW oscillator 3 is corrected by the phase control section 8 in accordance with the amplified output carrier wave signal and the corrected clock signal is phase-synchronized with a carrier wave signal (signal of 40 kHz) output from the amplitude amplifying section 7. Then, the phase-synchronized clock signal (first clock signal) is output to the multiplying section 5, A/D converter 12 of the radio communicating unit 2, and D/A converter 14 of the radio communicating unit 2 by the phase control section 8.

Moreover, the frequency of the output first clock signal is multiplied by predetermined times by the multiplying section 5 and the first clock signal (second clock signal) multiplied by predetermined times is output to the receiving circuit 11 and transmitting circuit 15 of the radio communicating unit 2. Then, the A/D converter 12 and D/A converter 14 of the radio communicating unit 2 are operated at the timing decided by the output first clock signal, the receiving circuit 11 and transmitting circuit 15 are operated at the timing decided by the second clock signal, and transmission and reception (communication) of predetermined data is performed with another radio communicating apparatus 100.

Furthermore, it is assumed that when the communication is performed, the standard time and frequency signal receiving section 6 cannot receive a standard time and frequency signal. Then, outputting of a carrier wave signal is stopped by the standard time and frequency signal receiving section 6, a clock signal output from the SAW oscillator 3 is divided by the phase control section 8 and output to the multiplying section 5, A/D converter 12 and D/A converter 14 of the radio communicating unit 2, and the above communication is continued.

Thus, the radio communicating apparatus 100 of this embodiment corrects a signal synchronizing with the carrier wave of a standard time and frequency signal, that is, corrects the phase of a clock signal so that a carrier wave signal phase-synchronizes with the clock signal. Therefore, when a standard time and frequency signal can be received, it is possible to correct a clock signal in accordance with a carrier wave signal which can be generated from the standard time and frequency signal anytime. Therefore, even if operational environments (such as temperatures) of the SAW oscillator 3 are changed and the phase of a clock signal output from the SAW oscillator 3 is fluctuated due to the change, it is possible to synchronize the fluctuated clock signal with a standard time and frequency signal, that is, the carrier wave of a radio wave for providing a very accurate frequency standard and a time service signal. As a result, it is possible to improve the accuracy of a clock signal in accordance with the correction.

Moreover, in the case of this embodiment, when the processing for synchronizing the phase of a clock signal output from the SAW oscillator 3 with a carrier wave signal is performed in each of a plurality of radio communicating apparatuses 100 constituting the radio communicating system 1000, it is possible to accurately synchronize a clock signal of a communication counterpart with a clock signal of its own and as a result, it is possible to improve the communication quality of predetermined data.

Furthermore, in the case of this embodiment, a clock signal is generated by the comparatively inexpensive SAW oscillator 3 though a temperature characteristic is inferior. Therefore, it is possible to decrease the fabrication cost compared to the case of using a method for generating a clock signal by a comparatively expensive voltage control quartz oscillator superior in a temperature characteristic and as a result, it is possible to decrease the radio communicating apparatus 100 in cost.

Furthermore, in the case of this embodiment even if a standard time and frequency signal cannot be received, it is possible to use a clock signal similarly to the case of a method for using a normal clock signal generating unit by using a clock signal output from the SAW oscillator 3 and continue the above communication.

Thus, the SAW oscillator 3 in FIG. 2 constitutes the oscillators of claims and subsequently similarly, the standard time and frequency signal receiving section 6 in FIG. 2 constitutes a carrierwave signal generating section, the phase control section 8 in FIG. 2 constitutes a phase correcting section, the radio communicating apparatus 100 in FIG. 2 constitutes a communicating apparatus, and the radio communicating unit 2 in FIG. 2 constitutes a communicating section.

A clock signal correcting circuit and a communicating apparatus of the present invention are not restricted to contents of the above embodiment but it is possible to properly modify them in a range not deviated from the gist of the present invention.

## Claims

1. A clock signal correcting circuit for correcting a clock signal output from a predetermined oscillator, comprising a standard time and frequency signal receiving section for receiving a standard time and frequency signal, a carrier wave signal generating section for generating a carrier wave signal synchronizing with the carrier wave of the received standard time and frequency signal, and a phase correcting section for correcting the phase of the clock signal so that the generated carrier wave signal phase-synchronizes with the clock signal.

2. The clock signal correcting circuit according to claim 1, wherein the predetermined oscillator is an SAW oscillator.

3. The clock signal correcting circuit according to claim 1 or 2, wherein the phase correcting section corrects the phase of the clock signal so that the carrier wave signal generated by the carrier wave signal generating section phase-synchronizes with the clock signal when the standard time and frequency signal receiving section receives a standard time and frequency signal and stops the correction of the phase when the standard time and frequency signal receiving section does not receive the standard time and frequency signal.

4. A communicating apparatus capable of performing at least either of transmission and reception of predetermined data, comprising a standard time and frequency signal receiving section for receiving a standard time and frequency signal, a carrier wave signal generating section for generating a carrier wave signal synchronizing with the carrier wave of the received standard time and frequency signal, a phase correcting section for correcting the phase of a clock signal output from a predetermined oscillator so that the generated carrier wave signal phase-synchronizes with the clock signal, and a communicating section capable of performing at least either of transmission and reception of the predetermined data in accordance with the corrected clock signal.

5. The communicating apparatus according to claim 4, wherein the predetermined oscillator is an SAW oscillator.

6. The communicating apparatus according to claim 4 or 5, wherein the communicating section is able to perform at least either of transmission and reception of the predetermined data in accordance with a clock signal whose phase is corrected by the phase correcting section when the standard time and frequency signal receiving section receives a standard time and frequency signal and able to perform at least either of transmission and reception of the predetermined data in accordance with a clock signal output from the predetermined oscillator when the standard time and frequency signal receiving section does not receive a standard time and frequency signal.
